**Europäisches Patentamt**

**European Patent Office**

**Office européen des brevets**

(19)

(11) Publication number: **0 065 830**
**A1**

(12) # EUROPEAN PATENT APPLICATION

(21) Application number: **82302258.7**

(22) Date of filing: **30.04.82**

(51) Int. Cl.³: **G 01 R 33/06**

(30) Priority: **07.05.81 GB 8113996**

(43) Date of publication of application:
**01.12.82 Bulletin 82/48**

(84) Designated Contracting States:
**DE FR GB NL SE**

(71) Applicant: **EMI Limited**
**Blyth Road**
**Hayes Middlesex, UB3 1BP(GB)**

(72) Inventor: **Green, Ian MacDonald**
**"Westwood" High Street Buckie**
**Banffshire Scotland(GB)**

(74) Representative: **Marsh, Robin Geoffrey**
**Thorn EMI Patents Limited The Quadrangle Westmount**
**Centre Uxbridge Road**
**Hayes Middlesex, UB4 0HB(GB)**

(54) **Magnetoresistive sensor arrangement.**

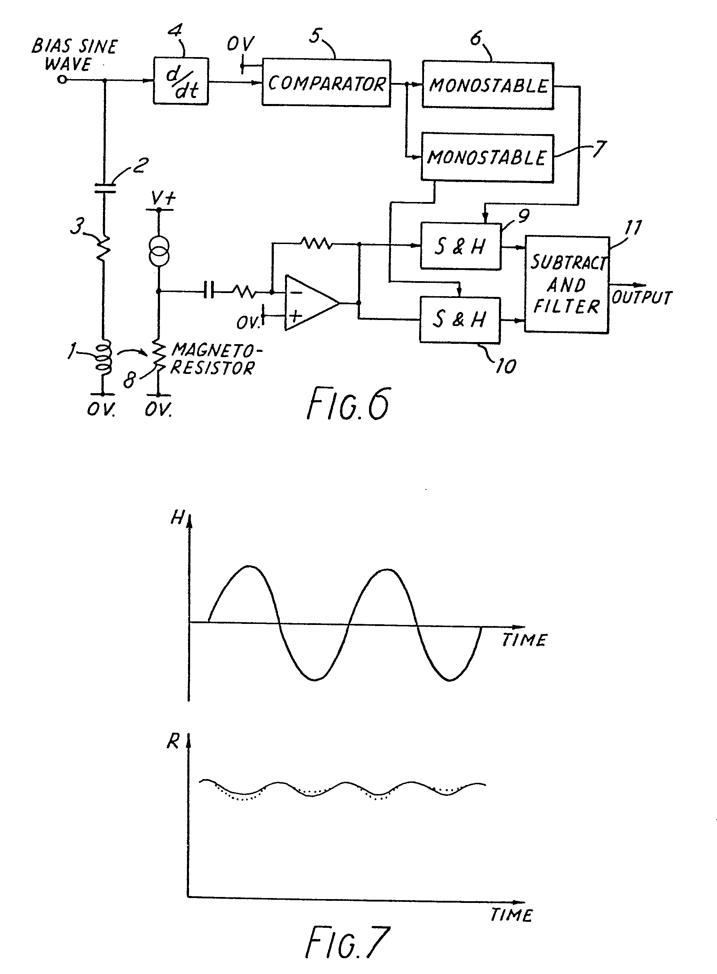

(57) A magnetoresistive sensor arrangement (Figure 6) includes a coil (1) driven by an oscillator circuit which subjects a magnetoresistive sensor (8) to an a.c. magnetic biassing field. A circuit responds to consecutive peaks in the magnetic biassing field to sample the magnetoresistance of the sensor, consecutively sampled resistance values being differenced by a differencing circuit (11) to generate an output signal indicative of an externally applied magnetic field.

FIG.6

EP 0 065 830 A1

: 1 :

## MAGNETORESISTIVE SENSOR ARRANGEMENT

This invention relates to magnetoresistive sensor arrangements.

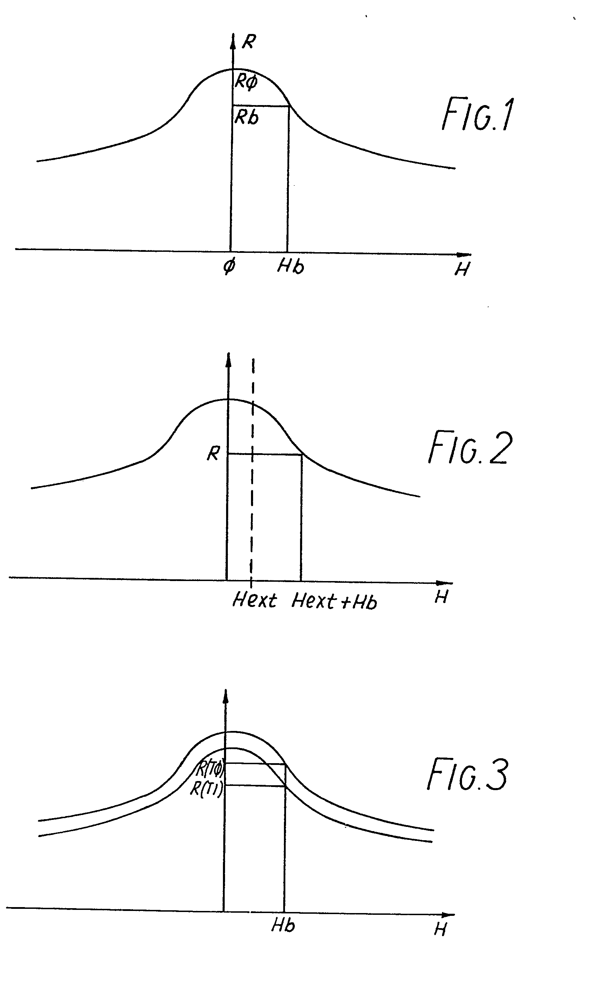

The resistance of a magnetoresistive sensor is a function of the local magnetic field, as shown in Figure 1. In practice, and undesirably, the resistance of such a sensor is also a function of other parameters such as temperature, time, and the stress imposed on the resistance element. To minimise these unwanted effects, it is common practice to operate a pair of elements differentially, in such a way that the unwanted signals substantially cancel. Even so, element matching is still a considerable problem.

An object of the invention is to provide a magnetoresistive sensor arrangement wherein signals from a single magnetoresistive sensor are processed in such a way that unwanted components are filtered out, leaving only the magnetic field dependence.

According to the present invention there is provided a magnetoresistive sensor arrangement (Fig. 6) comprising a magnetoresistive sensor (8) and a circuit responsive to the resistance of said sensor to generate an output signal representative of an externally applied magnetic field characterised in that said circuit comprises biassing means (1) for subjecting the sensor to a time varying, oscillatory magnetic field and means (4-11) capable of comparing resistance values exhibited by the sensor in coincidence with respective excursions of said time varying magnetic field which are of equal magnitude and opposite sense, thereby to generate said output signal.

The invention takes advantage of the symmetry of the curve shown in Figure 1. Whereas the unwanted effects shift the curve vertically, applied magnetic fields shift it horizontally. The invention resides in the application of a small a.c. bias field to the sensor, allowing measurements on both sides of the curve to be taken. In the absence of an external magnetic field, these measurements will be equal, and can be subtracted (with appropriate timing) to give the correct answer of zero field. When a magnetic field is present, shifting the curve horizontally, subtracting the measurements gives a measure of the magnitude and sign of the applied field. Thus the sensor is automatically calibrated against itself.

In order that the invention may be clearly understood and readily carried into effect an explanation will first be given of how a magnetoresistive sensor is used conventionally to measure magnetic fields and reference will be made to the drawings of which,

Figure 1 shows the variation of resistance of a magnetoresistive sensor with applied magnetic field,

Figure 2 shows the variation of resistance of a magnetoresistive sensor with applied magnetic field in the presence of an external magnetic field, and

Figure 3 illustrates the effect of temperature change on the variation of resistance of a magnetoresistive sensor with applied magnetic field.

Particular embodiments of the invention are then described by reference to the remaining drawings of which

Figures 4 and 5 illustrate respectively the effect of applying a biassing field of equal magnitude and opposite sign to a magnetoresistive sensor both in the absence and presence of an external magnetic field,

Figure 6 is a circuit showing a particular magnetoresistive sensor arrangement,

Figure 7 shows the variation with time of the biassing field and magnetoresistance of the sensor useful in understanding the circuit of Figure 6, and

Figures 8 and 9 show alternative circuit arrangements.

Referring again to Figure 1, it will be observed that the zero field resistance (R$\emptyset$) changes very little in response to small applied fields. Therefore the resistor is biased into a region of maximum sensitivity by means of a bias field Hb. The resulting resistance (Rb) is altered by external fields, and can accordingly be used as a measure of that field.

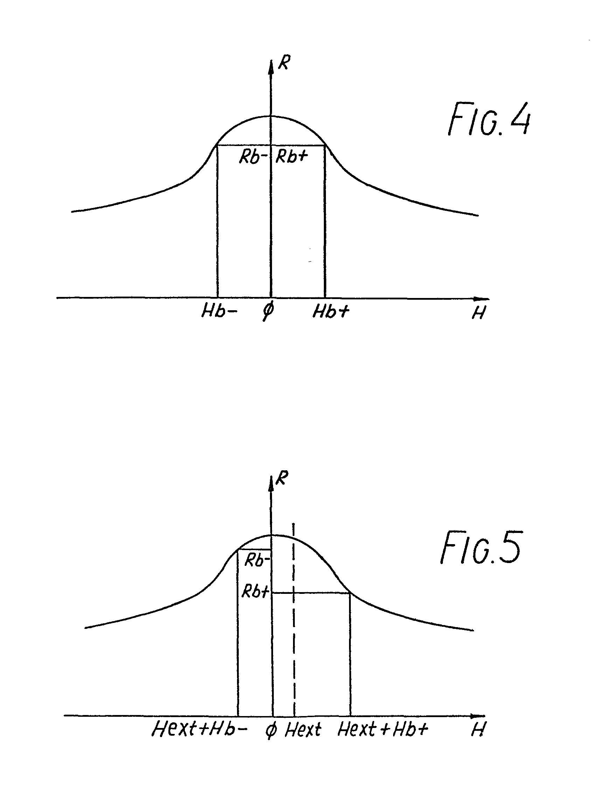

Figure 2 shows graphically how an external field changes the measured resistance, and Figure 3 shows graphically how a temperature change can produce the same effect. As mentioned above, operation of the resistance elements in pairs, in a bridge configuration, can substantially reduce the effect of temperature and other unwanted changes. However it is necessary to so dispose the pair that they are equally affected by · temperature changes, while being unequally affected by the external field to be measured. In contrast, and in accordance with the invention, the resistance of a single sensor is monitored under the application of equal and opposite bias fields and the resistance values so monitored are compared. The method of applying the fields will be described hereinafter. Figure 4 demonstrates that, due to the symmetry of the curve, equal and opposite bias fields Hb+ and Hb- produce equal resistances Rb+ and Rb- in the absence of any other external applied field. Subtracting Rb+ and Rb- gives the correct answer of zero applied field. Clearly, temperature changes which shift the whole curve vertically will change Rb+ and Rb- equally, leaving the difference at zero as before. It is not necessary to know the bias field exactly, as long as Hb+ and Hb- are equal.

The effect of an external field is shown in Figure 5. Rb+ and Rb- are driven in opposite directions, and their difference is a measure of the external field.

The bias field Hb should be an a.c. field, so as to allow measurements on both sides of the curve of Figure 1. The field amplitude is not particularly critical, nor is its waveform or uniformity. Its frequency, however, should be at least equal to the sum of the highest frequency to be measured in the magnetic field, and the highest interfering frequency from the unwanted components.

As an example of the use of the invention, Figure 6 shows a practical circuit. A sine wave is chosen as the bias waveform to minimise external radiation from a bias coil 1. This coil is driven via a series capacitor 2 (to remove d.c.) and a series resistor 3, to define the current. The input sine wave is also differentiated in a differentiating circuit 4 so that the peaks of the sine wave produce zeros from the differentiator. These zeros are detected by a circuit in the form of a comparator 5, and separate monostables 6 and 7 which respond to rising and falling edges to generate respective trigger output signals. The monostable outputs are, in turn used to sample the amplified signal from a magnetoresistor 8 in respective sample-and-hold circuits 9 and 10. Thus the signal is sampled separately on the positive and negative peaks of the bias current. The samples are subtracted and filtered in a circuit 11 to yield an output approximately proportional to the external magnetic field. Figure 7 shows both the bias field and the signal from the magnetoresistor as a function of time. The effect of an external field is shown by the dashed line.

Standard precautions should be taken to avoid direct pickup between the sensor and the bias field. Residual pickup can be measured by turning off the constant current through the sensor, and then cancelled either manually or automatically.

The invention, as so far described, allows the sensor to provide an accurate measure of zero field. In the presence of a field, however, the linearity and constant of proportionality depend on the sensor characteristics. In order to reduce this dependence it is preferable for the sensor to be used in a feedback mode.

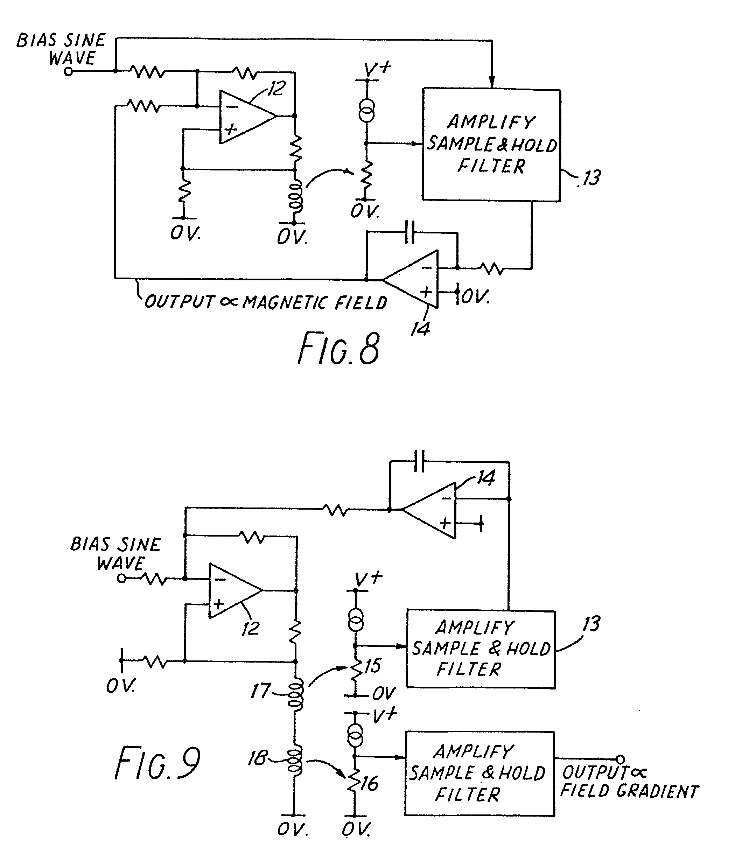

D.c. feedback is a known technique whereby a local magnetic field is created in opposition to the external field, so as to increase the dynamic range of the sensor. Its use with the invention is illustrated in Figure 8. An amplifier 12, connected as a current source, has two inputs. One is the a.c. bias described above, while the other is a d.c. feedback signal derived from the amplifier and detector unit as described in Figure 6. The components 4-7 and 9-11 inclusive of Figure 6 are included in the box labelled 13 in Figure 8. The use of an integrator (14) in the feedback loop is a known technique which, if properly applied, ensures loop stability and makes the integrator output directly proportional to the external magnetic field. The coil, which applied the a.c. bias, can also be used to apply the compensating d.c. field. The linearity and constant of proportionality is a property of this coil, rather than being a property of the magnetoresistive element.

In practice, using known techniques, the sample and hold circuits 9, 10, filter 11 and integrator 12 can all be replaced by a single amplifier operating as an integrating gated phase-sensitive detector.

An extension of this arrangement is shown in Figure 9, wherein two magnetoresistors 15 and 16, spatially separated, are used to measure a field gradient. Each resistor has its own compensating coil as shown at 17 and 18 respectively. The two coils are matched, and the same current flows in each. One sensor (15) is operated with the feedback arrangement shown in Figure 8, which nulls the local magnetic field. The second sensor (16) is used to sense its own local magnetic field, which is equal to the field difference between the two sensors when the compensating current is switched off. In other words the output from the second sensor is proportional to the field gradient. Although the coils must be matched for equal magnetic fields, for example by using solenoids with equal numbers of turns, there is no need for the sensors to be matched.

The invention finds application in the measurement of small d.c. or low frequency magnetic fields. One example is a solid state compass using two sensors oriented at right angles.

What we claim is:

1.      A magnetoresistive sensor arrangement (Fig. 6) comprising a magnetoresistive sensor (8) and a circuit responsive to the resistance of said sensor to generate an output signal representative of an externally applied magnetic field characterised in that said circuit comprises biassing means (1) for subjecting the sensor to a time varying, oscillatory magnetic field and means (4-11) capable of comparing resistance values exhibited by the sensor in coincidence with respective excursions of said time varying magnetic field which are of equal magnitude and opposite sense, thereby to generate said output signal.

2.      A sensor arrangement according to Claim 1 wherein said means capable of comparing resistance values comprises first circuit means (4-7) responsive to consecutively occuring peak excursions of said time varying magnetic field to generate respective trigger signals, second circuit means (9,10) responsive to said trigger signals to sample the resistance of the sensor and generate respective signal levels indicative of the sampled resistances, and third circuit means (11) for differencing said respective signal levels to generate said output signal representative of an externally applied magnetic field.

3.      A sensor arrangement according to Claim 2 wherein said biassing means comprises an oscillator circuit electrically connected to a coil (1) and said first circuit means comprises a differentiating circuit (4) electrically connected in parallel with said coil to differentiate the output of said oscillator circuit and a further circuit responsive to consecutively occurring nulls in the output of said differentiating circuit to generate the said trigger signals.

4.      A sensor arrangement according to Claim 3 wherein said further circuit comprises a comparator (5) responsive to consecutively occurring nulls in the output of the differentiating circuit to generate respective comparison signals and first and second monostable circuits each responsive to a respective comparison signal to generate a respective trigger signal.

5.      A sensor arrangement according to Claim 3 or Claim 4 wherein said second circuit means comprises a pair of sample and hold circuits each responsive to a respective trigger signal to sample the resistance of the sensor.

6.       A sensor arrangement according to any one of Claims 1 to 5 comprising a feed back circuit for applying to said coil a further signal related to the said output signal.

7.       A sensor arrangement according to Claim 6 wherein said feed back circuit comprises an amplifier circuit provided with a first input for receiving a first input signal derived from said oscillator circuit, a second input for receiving a second input signal derived from said output signal indicative of an externally applied magnetic field, and an output location electrically connected to the said coil.

8.       A sensor arrangement according to Claim 6 or Claim 7 comprising two magneto resistive sensors in spaced apart relationship, a pair of coils connected electrically in series with a common oscillator circuit, each being arranged to subject a respective sensor only to a time varying oscillatory magnetic field, respective said means capable of comparing resistance values exhibited by each sensor to generate respective output signals, and a feed back circuit for applying jointly to both said coils a signal related to one only of said output signals the said one output signal being representative of an externally applied magnetic field and, the other output signal being representative of a gradient, between the sensors, of said externally applied magnetic field.

0065830

FIG.1

FIG.2

FIG.3

FIG.4

FIG.5

FIG.6

FIG.7

0065830

BIAS SINE WAVE

AMPLIFY SAMPLE & HOLD FILTER — 13

OUTPUT ∝ MAGNETIC FIELD

FIG.8

BIAS SINE WAVE

AMPLIFY SAMPLE & HOLD FILTER — 13

AMPLIFY SAMPLE & HOLD FILTER

OUTPUT ∝ FIELD GRADIENT

FIG.9

0065830

European Patent Office

**EUROPEAN SEARCH REPORT**

Application number

EP 82302258.7

## DOCUMENTS CONSIDERED TO BE RELEVANT

| Category | Citation of document with indication, where appropriate, of relevant passages | Relevant to claim |
|---|---|---|
| X | DE – B – 1 297 755 (SIEMENS)   * Column 3, lines 12-29 *   ---- | 1 |

**CLASSIFICATION OF THE APPLICATION (Int. Cl. ³)**

G 01 R 33/06

**TECHNICAL FIELDS SEARCHED (Int.Cl. ³)**

G 01 C 17/00

G 01 R 33/00

G 01 V  3/00

**CATEGORY OF CITED DOCUMENTS**

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

| X | The present search report has been drawn up for all claims |
|---|---|

| Place of search | Date of completion of the search | Examiner |
|---|---|---|
| VIENNA | 11-08-1982 | KUNZE |

EPO Form 1503.1  06.78